# EUROPÄISCHE PATENTSCHRIFT

(11) **EP 2 647 037 B1**
(45) Veröffentlichungstag und Bekanntmachung des Hinweises auf die Patenterteilung: **01.04.2015**
(21) Anmeldenummer: 11779713.4
(22) Anmeldetag: 11.11.2011
(51) Int. Cl.: H01L 21/30, H01L 31/18, H05H 1/34, H05H 1/48

(54) **VERFAHREN ZUR WASSERSTOFFPASSIVIERUNG VON HALBLEITERSCHICHTEN**
METHOD FOR THE HYDROGEN PASSIVATION OF SEMICONDUCTOR LAYERS
PROCÉDÉ DE PASSIVATION À L'HYDROGÈNE DE COUCHES DE SEMI-CONDUCTEURS

(30) Priorität: 03.12.2010 DE 102010053214
(43) Veröffentlichungstag der Anmeldung: 09.10.2013
(73) Patentinhaber: Evonik Degussa GmbH, 45128 Essen (DE)
(72) Erfinder: STENNER, Patrik, 63452 Hanau (DE); WIEBER, Stephan, 76137 Karlsruhe (DE); CÖLLE, Michael, 90596 Schwanstetten (DE); PATZ, Matthias, 46240 Bottrop (DE); CARIUS, Reinhard, 52428 Jülich (DE); BRONGER, Torsten, 52064 Aachen (DE)
(74) Vertreter: Olbricht, Gerhard
(86) Internationale Anmeldenummer: PCT/EP2011/069921
(87) Internationale Veröffentlichungsnummer: WO 2012/072403

(56) Entgegenhaltungen:
- WO-A1-2008/061602
- WO-A1-2012/072401
- WO-A1-2012/072406
- US-A- 5 424 103

## Beschreibung

Die vorliegende Erfindung betrifft ein Verfahren zur Wasserstoffpassivierung von Halbleiterschichten, die mit dem Verfahren herstellbaren passivierten Halbleiterschichten und ihre Verwendung.

Halbleiterschichten können in Abhängigkeit von dem eingesetzten Herstellungsverfahren so genannte offene Bindungen (Englisch: dangling bonds) in der Halbleiterstruktur aufweisen. Dadurch können jedoch die Halbleitereigenschaften verschlechtert werden. Zum Beispiel im Fall von Solarzellen aufweisend Halbleiterschichten mit offenen Bindungen kann dies zu einer Verringerung des lichtinduzierten Ladungstransportes führen. Um die Halbleitereigenschaften zu verbessern, beziehungsweise um offene Bindungen mit Wasserstoffatomen zu sättigen, kann in die Halbleiterschicht, insbesondere nach der Herstellung der Schicht, Wasserstoff eingetragen werden. Dieser Eintrag von Wasserstoff wird als Wasserstoffpassivierung bezeichnet wird.

In der Literatur sind einige Verfahren zur Wasserstoffpassivierung von Halbleiterschichten beschrieben:
Die Druckschrift EP 0 419 693 A1 beschreibt eine Wasserstoffpassivierung von Silicium durch eine Temperaturbehandlung in wasserstoffhaltiger Atmosphäre. Vorzugsweise werden dabei Temperaturen von bei 250 °C bis 500 °C eingesetzt. Das dort beschriebene Verfahren ist jedoch apparativ sehr aufwändig.
Die Druckschrift US 5,304,509 A offenbart, dass ein Siliciumsubstrat dadurch mit Wasserstoff passiviert werden kann, dass das Siliciumsubstrat zuerst rückseitig mit einem Wasserstoffionenstrahl behandelt und anschließend (vorderseitig) mit elektromagnetischer Strahlung bestrahlt wird. Nach der Behandlung mit dem Wasserstoffionenstrahl diffundieren dabei die implantierten Wasserstoffionen schnell durch das Substrat und heben dann nach der Bestrahlung die aufgetretenen Defekte auf. Nachteilig hierbei ist jedoch, dass der Einsatz des Wasserstoffionenstrahls (erzeugt über eine Kaufmann-Quelle) zu einer Beschädigung der Substratoberfläche führt. Aus diesem Grund kann der Wasserstoffionenstrahl auch nur rückseitig angewandt werden.
US 5,424,103 A beschreibt ein Verfahren zur Herstellung eines Halbleiters, bei dem eine Korona-Entladung eingesetzt wird. Der Einsatz einer Bogenentladung wird als nachteilig herausgestellt.
Die Druckschrift EP 0 264 762 A1 beschreibt ein Verfahren zur Passivierung, bei dem zur Passivierung geeignete Ionen auf ein elektrisch leitfähiges Material einwirken, wobei auf ein Hochfrequenz-Gasentladungs-Plasma eine überlagerte Gleichspannung einwirkt, die zur Beschleunigung der zur Passivierung geeigneten Ionen auf das elektrisch leitende Material dient. Vorteilhaft an diesem Passivierungsverfahren ist zwar die Möglichkeit einer großflächigen und geometrieunabhängigen Substratbehandlung und die Möglichkeit von kurzen Prozesszeiten, nachteilig ist jedoch der hohe apparative Aufwand des Verfahrens, der unter anderem auf die Erzeugung des Plasmas bei Niederdruck (angegeben: 7,6 · 10⁻⁴ Torr für Wasserstoff) zurückzuführen ist. Dieser führt dazu, dass das Verfahren in der Regel in einem geschlossenen Raum durchgeführt werden muss, so dass eine Anwendung des Passivierungsverfahrens in einem kontinuierlichen Prozess nicht möglich ist.
US 4,343,830 A beschreibt ein Verfahren zur Passivierung polykristalliner Silicium-Solarzellen, bei dem ein Hochdruck-Wasserstoff-Plasma (bevorzugter Druck 760 Torr) eingesetzt wird. Gegenüber dem bei EP 0 264 762 A1 beschriebenem Verfahren besteht somit zwar der Vorteil, dass eine Erzeugung des Plasmas bei Niederdruck nicht mehr erforderlich ist, nachteilig an dem dort eingesetzten Hochdruck-Wasserstoff-Plasma ist jedoch, dass auch hier der apparative Aufwand sehr groß ist, da zur Erzeugung des Hochdruck-Wasserstoffplasmas in der Regel Radiofrequenzgeneratoren und Impedanzeinheiten verwendet werden müssen.
US 6,130,397 B1 beschreibt ein apparativ sehr aufwändiges Verfahren zur Behandlung dünner Schichten mit einem induktiv gekoppelt erzeugten Plasma. Weiterhin ist das dort beschriebene Verfahren nicht geeignet für eine gute Wasserstoffpassivierung von Halbleiterschichten.

Demgegenüber ist es nun die Aufgabe der vorliegenden Erfindung, die Nachteile des Standes der Technik zu vermeiden. Insbesondere ist es die Aufgabe der vorliegenden Erfindung, ein apparativ wenig aufwändiges Verfahren zur Wasserstoffpassivierung von Halbleiterschichten bereitzustellen, das nicht zu einer Beschädigung des Substrats bzw. der darauf aufgebrachten Halbleiterschichten führt, das in einem kontinuierlichen Prozess angewandt werden kann und das zu einer besonders guten Passivierung führt.

Diese Aufgabe wird vorliegend durch das erfindungsgemäße Verfahren zur Wasserstoffpassivierung von Halbleiterschichten gelöst, bei dem die Passivierung durch Einsatz einer Lichtbogenplasmaquelle erfolgt.

Neben der Lösung der zuvor genannten Aufgaben hat das erfindungsgemäße Verfahren darüber hinaus den Vorteil, dass das Verfahren unter Atmosphärendruck angewandt werden kann und sehr wirtschaftlich ist.

Unter einem Verfahren zur Wasserstoffpassivierung von Halbleiterschichten im Sirine der vorliegenden Erfindung ist dabei ein Verfahren zur Absättigung der bereits erwähnten, an den Orten der Defekte befindlichen offenen Bindungen zu verstehen, bei dem atomarer Wasserstoff erzeugt und an den jeweiligen Ort des Defektes an der Oberfläche und im Innern der Halbleiterschicht transportiert wird, wobei der atomare Wasserstoff dann die jeweilige offene(n) Bindung(en) absättigt. Eine erfolgte Wasserstoffpassivierung wird zum Beispiel für Solarzellen durch eine Erhöhung des lichtinduzierten Ladungstransports relativ zu dem Zeitpunkt vor erfolgter Passivierung messbar. Allgemein lässt sich die Wasserstoffpassivierung IRspektroskopisch durch die Veränderung der Banden des jeweiligen Halbleiters (für Siliciumschichten: durch die Veränderung der charakteristischen Bande bei 2000 cm⁻¹) überprüfen.

Unter einer Halbleiterschicht ist dabei eine Schicht zu verstehen, welche mindestens einen Elementhalbleiter, bevorzugt ausgewählt aus der Gruppe bestehend aus Si, Ge, α-Sn, C, B, Se, Te und Mischungen davon, und/oder mindestens einen Verbindungshalbleiter, insbesondere ausgewählt aus der Gruppe, bestehend aus IV-IV-Halbleitern, wie SiGe, SiC, III-V-Halbleitern, wie GaAs, GaSb, GaP, InAs, InSb, InP, InN, GaN, AIN, AlGaAs, InGaN, oxidischen Halbleitern, wie InSnO, InO, ZnO, II-VI-Halbleitern, wie ZnS, ZnSe, ZnTe, III-VI-Halbleitern, wie GaS, GaSe, GaTe, InS, InSe, InTe, I-III-VI-Halbleitern, wie CulnSe2, CulnGaSe2, CulnS2, CulnGaS2, und Mischungen davon, umfasst oder daraus besteht.

Bevorzugt, weil dies zu einer besonders guten Wasserstoffpassivierung des Halbleiters führt, handelt es sich bei der zu passivierenden Halbleiterschicht jedoch um eine siliciumhaltige Schicht, d.h. um eine im Wesentlichen reine halbleitende Siliciumschicht, eine u. a. Silicium enthaltende Verbindungshalbleiter-Schicht oder eine auf Silicium basierende, darüber hinaus Dotierstoffe enthaltende Schicht.

Ganz besonders bevorzugt, weil für entsprechende Schichten mit dem erfindungsgemäßen Verfahren eine besonders hohe Passivierung und somit besonders gute elektrische Eigenschaften der Halbleiterschicht erreicht werden können, ist die siliciumhaltige Halbleiterschicht eine siliciumhaltige Schicht, die thermisch oder mit elektromagnetischer Strahlung im Wesentlichen aus flüssigen Hydridosilanen hergestellt wurde.

Bei der erfindungsgemäß einzusetzenden Lichtbogenplasmaquelle handelt es sich um eine Quelle für ein durch eine selbsterhaltende Gasentladung zwischen zwei Elektroden mit ausreichend hoher elektrischer Potentialdifferenz erzeugtes Plasma, bei dem das eingesetzte Gas mindestens eine Wasserstoffquelle aufweist. Entsprechende Plasmen weisen Temperaturen von ≤ 3000 K auf.

Bevorzugt einsetzbare Lichtbogenplasmaquellen, da bei ihnen die Bildung der Lichtbogenplasmas außerhalb der eigentlichen Reaktionszone erfolgt und anschließend das Plasma mit relativ hoher Strömungsgeschwindigkeit und somit schnell auf die Oberfläche des zu behandelnden Substrates gerichtet werden kann, wodurch die Plasmabildung durch das Substrat nicht beeinflusst wird und eine hohe Prozesssicherheit resultiert, sind solche, bei denen das Plasma durch eine Hochdruck-Gasentladung bei Stromstärken von < 45 A generiert wird.

Dabei ist unter einer Hochdruck-Gasentladung bevorzugt eine Gasentladung bei Drücken von 0,5 - 8 bar, bevorzugt 1 - 5 bar zu verstehen.

Besonders bevorzugt wird die Hochdruck-Gasentladung bei Stromstärken von 0,1 - 44 A, bevorzugt 1,5 - 3 A Gleichstrom durchgeführt. Entsprechend hergestellt Plasmen haben den Vorteil, dass sie potentialfrei sind, und daher kleine Beschädigung der Oberfläche durch Entladung verursachen können. Weiterhin findet kein Fremdmetalleintrag auf die Oberfläche statt, da das Substrat nicht als Gegenpol dient.

Die Entladung findet zwischen zwei Elektroden, der Anode und der Kathode, statt. Zur Erzielung einer besonders guten Plasmenbildung kann dabei insbesondere die Kathode speziell ausgestaltet werden.

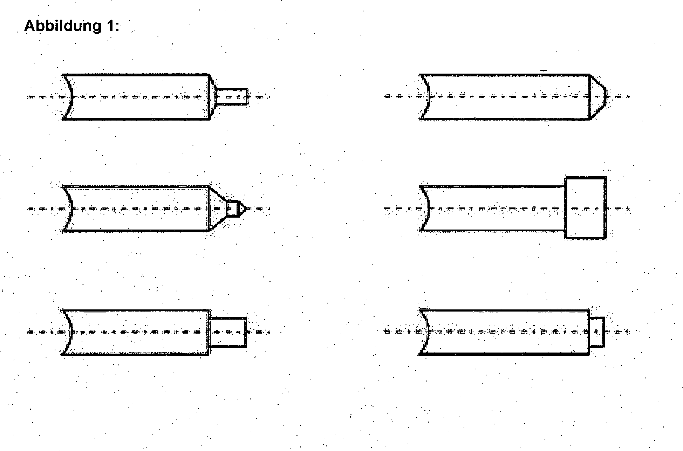

Weiterhin werden zur Vermeidung von Oberflächenschäden bevorzugt geringe Stromstärken verwendet. Besonders gut für den Einsatz bei niedrigen Stromstärken einsetzbare Kathodenformen sind in Abbildung 1 dargestellt.

Bevorzugt wird als Plasmaerzeuger ein indirekter Plasmaerzeuger eingesetzt, d.h. der Lichtbogen existiert nur im Plasmaerzeuger. Entsprechende indirekte Plasmaerzeuger haben den Vorteil, die bei direkten Plasmaerzeugern erfolgende Entladung auf dem Substrat zu vermeiden, die zu einer Oberflächenbeschädigung des Substrates bzw. der darauf befindlichen Halbleiterschicht führen kann. Entsprechend kann mit indirekten Plasmaerzeugern vorteilhaft die Passivierung durchgeführt werden. Der durch Entladung erzeugte Lichtbogen wird bei der indirekten Plasmaerzeugung durch einen Gasstrom nach außen getragen. Die Behandlung des Substrates kann dann vorzugsweise bei Atmosphärendruck erfolgen

Bevorzugte Plasmaerzeuger arbeiten bei einer Rechteckspannung bei 15 - 25 kHz, 0-400 V (bevorzugt 260 bis 300 V, insbesondere 280 V), 2,2- 3,2 A und einem Plasma Cycle von 50-100%.

Entsprechende Plasmen können zum Beispiel mit den unter der Handelsproduktbezeichnung Generator FG3002 der Firma Plasmatreat GmbH, Deutschland oder unter der Handelsproduktbezeichnung Plasmabeam der Firma Diener GmbH, Deutschland erhältlichen Lichtbogenplasmaquellen erzeugt werden.

Zur Erzielung besonders guter Eigenschaften wird die Lichtbogenplasmaquelle bei dem erfindungsgemäßen Verfahren bevorzugt derart eingesetzt, dass sich die Düse, aus der das Plasma austritt, in einem Abstand von 50 µm bis 50 mm, bevorzugt 1 mm bis 30 mm, insbesondere bevorzugt 3 mm bis 10 mm entfernt von der zu passivierenden Halbleiterschicht befindet. Bei einem zu dichten Abstand ist die Energiedichte zu hoch, so dass es zu einer Oberflächenbeschädigung des Substrates kommen kann. Bei einem zu weiten Abstand zerfällt das Plasma, so dass kein Effekt oder nur ein geringer Effekt auftritt.

Der aus der Düse austretende Plasmastrahl wird zur Erzielung einer besonders guten Passivierung bevorzugt in einem Winkel von 5 bis 90°, bevorzugt 80 bis 90°, besonders bevorzugt 85 bis 90° (in letzterem Fall: im wesentlichen rechtwinklig zur Substratoberfläche für planare Substrate) auf die auf dem Substrat befindliche Halbleiterschicht gelenkt.

Die Lichtbogenplasmaquelle weist eine Düse auf, aus der das Plasma austritt. Als Düsen für die Lichtbogenplasmaquelle eignen sich Spitzdüsen, Fächerdüsen oder rotierende Düsen, wobei bevorzugt Spitzdüsen eingesetzt werden, die den Vorteil haben, dass eine höhere punktuelle Energiedichte erreicht wird.

Eine besonders gute Passivierung wird, insbesondere für die o. g. Abstände der Düse von der zu behandelnden Halbleiterschicht, erzielt, wenn die Behandlungsgeschwindigkeit, bestimmt als behandelte Strecke der Halbleiterschicht pro Zeiteinheit, 0,1 bis 500 mm/s bei einer Behandlungsbreite von 1 bis 15 mm beträgt. Je nach der zu behandelnden Halbleiteroberfläche beschleunigt eine Temperierung weiterhin die Passivierung. Zur Erhöhung der Behandlungsgeschwindigkeit können mehrere Plasmadüsen hintereinander geschaltet werden.

Bei stationärer Verfahrensführung beträgt die Behandlungsbreite der Plasmadüse zur Erzielung einer guten Passivierung vorzugsweise 0,25 bis 20 mm, bevorzugt 1 bis 5 mm.

Das eingesetzte Gas zur Erzeugung des Lichtbogenplasmas weist weiterhin mindestens eine Wasserstoffquelle auf. Dabei hat sich überraschenderweise gezeigt, dass ein Betrieb der Lichtbogenplasmaquelle mit reinem Wasserstoff (nachteilig wegen der damit automatisch verbundenen Explosionsgefahr bei der Zündung des Plasmas) nicht erforderlich ist. Eine besonders gute und weiterhin sichere Wasserstoffpassivierung kann mit einem Gasgemisch aufweisend 0,1 - 5 Vol.-% H₂ und 99,9 - 95 Vol.-% Inertgas, bevorzugt 0,5 - 2 Vol.-% H₂ und 99,5 - 99 Vol.-% Inertgas erreicht werden.

Als Inertgas können ein oder mehrere in Bezug auf Wasserstoff im Wesentlichen inerte Gase, insbesondere Stickstoff, Helium, Neon, Argon, Krypton, Xenon oder Radon eingesetzt werden. Besonders gute Ergebnisse resultieren jedoch, wenn nur ein Inertgas eingesetzt wird. Ganz besonders bevorzugt wird als Inertgas Argon eingesetzt.

Dabei wirkt sich die Wahl der eingesetzten Gase direkt auf die Temperatur des Plasmas aus und bewirkt so eine unterschiedlich starke Erhitzung des Substrates sowie der darauf befindlichen Halbleiterschicht. Da eine zu starke Erhitzung des Substrates und der darauf befindlichen Halbleiterschicht zu Defekten in der Halbleiterschicht führen kann, werden die eingesetzten Gasgemische für die Plasmaerzeugung im Zusammenhang mit den weiteren Parametern für die Plasmaerzeugung so ausgewählt, dass Plasmatemperaturen von 300 bis 500 °C, bevorzugt 350 bis 450 °C resultieren.

Das erfindungsgemäße Verfahren wird bevorzugt bei Atmosphärendruck durchgeführt.

Um die Belastung des Substrats und der darauf befindlichen Halbleiterschicht bei der Plasmapassivierung zu minimieren, wird die Wasserstoffpassivierung bevorzugt derart durchgeführt, dass die zu passivierende Halbleiterschicht bei Einsatz der Lichtbogenplasmaquelle zusätzlich geheizt wird. Prinzipiell kann die Temperierung durch den Einsatz von Öfen, beheizten Walzen, Heizplatten, Infrarot- oder Mikrowellenstrahlung oder ähnlichem erfolgen. Besonders bevorzugt wird die Temperierung jedoch wegen des dann resultierenden geringen Aufwandes mit einer Heizplatte oder mit beheizten Walzen im Rolle-zu-Rolle-Verfahren durchgeführt.

Zur Erzielung einer besonders guten Wasserstoffpassivierung wird dabei die Halbleiterschicht bei Einsatz der Lichtbogenplasmaquelle auf Temperaturen von 150 - 500 °C, bevorzugt 200 - 400 °C geheizt.

Das Verfahren ermöglicht auch eine simultane Behandlung von mehreren übereinander liegenden Halbleiterschichten. Zum Beispiel können Halbleiterschichten unterschiedlichen Dotiergrads (p/n Dotierung) oder nicht dotierte Halbleiterschichten mit dem Verfahren passiviert werden. Das Verfahren ist dabei besonders gut geeignet zur Passivierung mehrerer übereinanderliegender Schichten mit Schichtdicken zwischen 10 nm und 3 µm, wobei Schichtdicken zwischen 10 nm und 60 nm, 200 nm und 300 nm und 1 µm und 2 µm bevorzugt sind.

Gegenstand der Erfindung sind weiterhin die nach dem erfindungsgemäßen Verfahren hergestellten passivierten Halbleiterschichten und ihre Verwendung zur Herstellung elektronischer oder optoelektronischer Erzeugnisse.

Das nachfolgend beigefügte Beispiel erläutert, ohne limitierend zu wirken, den Gegenstand der vorliegenden Erfindung weiter.

### Beispiel:

Ein mit einem ein flüssiges Hydridosilangemisch einsetzenden Spincoatingverfahren unter Erzeugung einer 110 nm dicken Siliciumschicht beschichteter SiO₂.Wafer wird auf einer Heizplatte auf 400°C erwärmt. Nach Erreichen der gewünschten Temperatur wird der Wafer für 30 s mit einem im einem Abstand von 6 mm senkrecht oberhalb des Wafers installierten Plasmajet (FG3002 der Firma Plasmatreat GmbH, 1,5 Vol.-% H2/Argon, Vordruck an der Plasmaeinheit 4 bar) behandelt.

Nach der Behandlung wird der Wafer von der Heizplatte genommen und per FT-IR vermessen. Die FT-IR-Spektren des Wafers zeigen einen Anstieg des Peaks bei einer Wellenzahl von 2000 cm⁻¹ und die Abnahme des Peaks bei 2090 cm⁻¹ für den behandelten Wafer. Dies belegt die Wasserstoffeinlagerung in den Halbleiter.

## Patentansprüche

1. Verfahren zur Wasserstoffpassivierung von Halbleiterschichten,
**dadurch gekennzeichnet, dass**
die Passivierung durch Einsatz einer Lichtbogenplasmaquelle erfolgt.

2. Verfahren nach Anspruch 1,
**dadurch gekennzeichnet, dass**
das die Halbleiterschicht eine siliciumhaltige Schicht ist.

3. Verfahren nach Anspruch 1 oder 2,
**dadurch gekennzeichnet, dass**
das die Lichtbogenplasmaquelle das Plasma durch eine Hochdruck-Gasentladung bei Stromstärken von < 45 A generiert.

4. Verfahren nach Anspruch 3,
**dadurch gekennzeichnet, dass**
die Hochdruck-Gasentladung bei Stromstärken von 0,1 - 44 A, bevorzugt 1,5 - 3 A Gleichstrom erfolgt.

5. Verfahren nach einem der vorhergehenden Ansprüche,
**dadurch gekennzeichnet, dass**
die Lichtbogenplasmaquelle ein indirekter Plasmaerzeuger ist.

6. Verfahren nach einem der vorhergehenden Ansprüche,
**dadurch gekennzeichnet, dass**
die Düse der Lichtbogenplasmaquelle, aus der das Plasma austritt, in einem Abstand von 50 µm bis 50 mm, bevorzugt 1 bis 30 mm entfernt von der zu passivierenden Halbleiterschicht angeordnet ist.

7. Verfahren nach einem der vorhergehenden Ansprüche,
**dadurch gekennzeichnet, dass**
der aus der Düse austretende Plasmastrahl in einem Winkel von 5 bis 90°, bevorzugt 80 bis 90°, besonders bevorzugt 85 bis 90° auf die auf dem Substrat befindliche Halbleiterschicht gelenkt wird.

8. Verfahren nach einem der vorhergehenden Ansprüche,
**dadurch gekennzeichnet, dass**
die Lichtbogenplasmaquelle ein Gasgemisch aufweisend 0,1 - 5 Vol.-% H₂ und 99,9 - 95 Vol.-% Inertgas, bevorzugt 0,5 - 2 Vol.-% H₂ und 99,5 - 99 Vol.-% Inertgas einsetzt.

9. Verfahren nach einem der vorhergehenden Ansprüche,
**dadurch gekennzeichnet, dass**
die Halbleiterschicht bei Einsatz der Lichtbogenplasmaquelle geheizt wird.

## Claims

1. Process for hydrogen passivation of semiconductor layers,
**characterized in that**
the passivation is effected by using a light arc plasma source.

2. Process according to Claim 1,
**characterized in that**
the semiconductor layer is a silicon-containing layer.

3. Process according to Claim 1 or 2,
**characterized in that**
the light arc plasma source generates the plasma by a high-pressure gas discharge at currents of < 45 A.

4. Process according to Claim 3,
**characterized in that**
the high-pressure gas discharge is effected at currents of 0.1 - 44 A, preferably 1.5 - 3 A DC.

5. Process according to any of the preceding claims,
**characterized in that**
the light arc plasma source is an indirect plasma generator.

6. Process according to any of the preceding claims,
**characterized in that**
the nozzle of the light arc plasma source from which the plasma emerges is arranged at a distance of 50 µm to 50 mm, preferably 1 to 30 mm, away from the semiconductor layer to be passivated.

7. Process according to any of the preceding claims,
**characterized in that**
the plasma jet leaving the nozzle is directed onto the semiconductor layer present on the substrate at an angle of 5 to 90°, preferably 80 to 90°, more preferably 85 to 90°.

8. Process according to any of the preceding claims,
**characterized in that**
the light arc plasma source uses a gas mixture comprising 0.1 - 5% by volume of H₂ and 99.9 - 95% by volume of inert gas, preferably 0.5 - 2% by volume of H₂ and 99.5 - 99% by volume of inert gas.

9. Process according to any of the preceding claims,
**characterized in that**
the semiconductor layer is heated when the light arc plasma source is used.

## Revendications

1. Procédé pour la passivation à l'hydrogène de couches semi-conductrices, **caractérisé en ce que** la passivation a lieu par l'utilisation d'une source de plasma à arc.

2. Procédé selon la revendication 1, **caractérisé en ce que** la couche semi-conductrice est une couche contenant du silicium.

3. Procédé selon la revendication 1 ou 2, **caractérisé en ce que** la source de plasma à arc génère le plasma par une décharge gazeuse à haute pression à des intensités de courant < 45 A.

4. Procédé selon la revendication 3, **caractérisé en ce que** la décharge gazeuse à haute pression a lieu à des intensités de courant de 0,1 - 44 A, de préférence de 1,5 - 3 A en courant continu.

5. Procédé selon l'une quelconque des revendications précédentes, **caractérisé en ce que** la source de plasma à arc est un générateur indirect de plasma.

6. Procédé selon l'une quelconque des revendications précédentes, **caractérisé en ce que** la buse de la source de plasma à arc, dont le plasma sort, est disposée à une distance éloignée de 50 µm à 50 mm, de préférence de 1 à 30 mm, de la couche semi-conductrice à passiver.

7. Procédé selon l'une quelconque des revendications précédentes, **caractérisé en ce que** le jet de plasma qui sort de la buse est dirigé sous un angle de 5 à 90°, de préférence de 80 à 90°, de manière particulièrement préférée de 85 à 90°, sur la couche semi-conductrice se trouvant sur le substrat.

8. Procédé selon l'une quelconque des revendications précédentes, **caractérisé en ce que** la source de plasma à arc utilise un mélange gazeux présentant 0,1 - 5% en volume de H₂ et 99,9 - 95 % en volume de gaz inerte, de préférence 0,5 - 2% en volume de H₂ et 99,5 - 99% en volume de gaz inerte.

9. Procédé selon l'une quelconque des revendications précédentes, **caractérisé en ce que** la couche semi-conductrice est chauffée lors de l'utilisation de la source de plasma à arc.
